(19) Europäisches Patentamt / European Patent Office / Office européen des brevets

(11) **EP 2 725 371 A2**

(12) **EUROPEAN PATENT APPLICATION**

(43) Date of publication:
**30.04.2014 Bulletin 2014/18**

(51) Int Cl.:
***G01R 31/36*** (2006.01)

(21) Application number: **13188845.5**

(22) Date of filing: **16.10.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **24.10.2012 JP 2012234468**
**24.09.2013 JP 2013196661**

(71) Applicant: **GS Yuasa International Ltd. Kisshoin**
**Minami-ku, Kyoto-shi**
**Kyoto 601-8520 (JP)**

(72) Inventor: **Sejima, Kenichi**
**Kyoto-shi, Kyoto 601-8520 (JP)**

(74) Representative: **Grünecker, Kinkeldey, Stockmair & Schwanhäusser**
**Leopoldstrasse 4**
**80802 München (DE)**

(54) **Electric storage condition detecting apparatus**

(57)     An electric storage condition detecting apparatus includes a voltage measurement circuit (24) and a CPU (70) that is a controller. The voltage measurement circuit (24) is a voltage detector that detects a voltage of a secondary battery (14). The CPU (70) performs a determination process (S70) for determining stabilizing time T of the secondary battery (14) based on an amount of charge Y of the secondary battery (14). With this configuration, the stabilizing time T is correctly obtained compared to a configuration in which the stabilizing time T is determined without considering the amount of charge. This shortens time for waiting stabilization of an open circuit voltage to be minimum.

FIG.5

START

↓

S10 MEASURE DISCHARGE CURRENT I

S20 IS DISCHARGE CURRENT I ZERO?
— NO → S30 CALCULATE AMOUNT OF CHARGE Y AND SOC

↓ YES

S40 START MEASURING ELAPSED TIME

S50 READ AMOUNT OF CHARGE Y

S60 DETECT TEMPERATURE H

S70 DETERMINE STABILIZING TIME T

S80 ELAPSED TIME LONGER THAN STABILIZING TIME T? — NO

↓ YES

S90 MEASURE OPEN CIRCUIT VOLTAGE

S100 ESTIMATE SOC

S110 RESET SOC

END

EP 2 725 371 A2

# Description

## FIELD

Technologies described herein relates to a technology for measuring an open circuit voltage of an electric storage device.

## BACKGROUND

Conventionally, there has been a method of estimating a state of charge of a secondary battery by measuring a stable open circuit voltage after charging or discharging and utilizing a correlative relation between the open circuit voltage and the state of charge. Since stabilizing time required for stabilizing the open circuit voltage is influenced by temperature, the stabilizing time is determined based on temperature information that is detected by a temperature detector (e.g., JP-A-2011-169831).

## SUMMARY

If the stabilizing time is obtained correctly, time required for waiting stabilization of the open circuit voltage is shortened to be minimum and the open circuit voltage is measured in a short time. Therefore, it has been required to calculate a correct stabilizing time.

This specification describes a technology for calculating a correct stabilizing time.

An electric storage condition detecting apparatus disclosed in this specification includes a voltage detector configured to detect a voltage of an electric storage device, and a controller configured to determine stabilizing time based on data corresponding to a charging capacity of the electric storage device. The stabilizing time is required for stabilizing an open circuit voltage of the electric storage device.

## BRIEF DESCRIPTION OF DRAWINGS

FIG. 1 is a schematic diagram illustrating a configuration of a battery pack according to a first embodiment.
FIG. 2 is a schematic diagram illustrating a configuration of a battery module.
FIG. 3 is a graph illustrating a relationship between an amount of charge and a stabilizing time.
FIG. 4 is a table illustrating stabilizing time in relation to an amount of charge and temperatures (correlation data table 2).
FIG. 5 is a flowchart of processes of an SOC estimation sequence.
FIG. 6 is a graph illustrating a relationship between an open circuit voltage and an SOC (correlation data 1).

FIG. 7 is a table illustrating stabilizing time in relation to SOCs and temperatures according to a second embodiment (correlation data table 3).
FIG. 8 is a flowchart of processes of an SOC estimation sequence.
FIG. 9 is a flowchart of processes of determining stabilizing time.
FIG. 10 is a graph illustrating a relationship between an amount of charge and stabilizing time.
FIG. 11 is a table illustrating stabilizing time in relation to an amount of charge and temperatures (correlation data table 5).
FIG. 12 is a graph illustrating a relationship between open circuit voltages and SOCs (correlation data 4).

## DESCRIPTION OF EMBODIMENTS

According to a first aspect, there is provided an electric storage condition detecting apparatus. The electric storage condition detecting apparatus includes a voltage detector configured to detect a voltage of an electric storage device, and a controller configured to determine stabilizing time based on data corresponding to a charging capacity of the electric storage device. The stabilizing time is required for stabilizing an open circuit voltage of the electric storage device.

With this apparatus, the stabilizing time is correctly obtained compared to a case in that the stabilizing time is determined without considering data corresponding to the charging capacity of the electric storage device. Therefore, waiting time required for stabilization of the open circuit voltage is shortened to be minimum.

According to a second aspect, the data is an amount of charge. In the electric storage condition detecting apparatus according to the second aspect, the stabilizing time is obtained correctly compared to a case in that the stabilizing time is determined without considering the amount of charge.

According to a third aspect, the data is an SOC. In the electric storage condition detecting apparatus according to the third aspect, the stabilizing time is obtained correctly compare to a case in that the stabilizing time is determined without considering the SOC.

According to a fourth aspect, the controller is further configured to determine the stabilizing time based on the data and a temperature of the electric storage device. In the electric storage condition detecting apparatus according to the fourth aspect, the stabilizing time is obtained more correctly because it is obtained with considering the amount of charge, the SOC and the temperature of the electric storage device.

According to a fifth aspect, the controller is further configured to determine the stabilizing time based on the data and a deterioration rate of an internal resistance of the electric storage device. In the electric storage condition detecting apparatus according to the fifth aspect, the stabilizing time is obtained more correctly because it is obtained with considering the amount of charge, the SOC and the deterioration rate of the internal resistance.

According to a sixth aspect, the controller is further configured to determine the stabilizing time based on the data, a temperature of the electric storage device, and a deterioration rate of an internal resistance of the electric storage device. In the electric storage condition detecting apparatus according to the sixth aspect, the stabilizing time is obtained more correctly because it is obtained with considering the amount of charge, the SOC, the temperature and the deterioration rate of the internal resistance.

According to a seventh aspect, the voltage detector is further configured to detect an open circuit voltage (an example of an electric storage condition) of the electric storage device after the stabilizing time is elapsed from end of charging or discharging. In the electric storage condition detecting apparatus according to the seventh aspect, waiting time for stabilizing the open circuit voltage is shortened to be minimum. Therefore, the open circuit voltage is detected in a short time.

According to an eighth aspect, the electric storage condition detecting apparatus further includes a current detector configured to detect a charge current or a discharge current of the electric storage device. The controller is further configured to perform a first estimation process to estimate an SOC of the electric storage device based on an initial amount of charge before charging or discharging and an accumulation value of charge currents or discharge currents of the electric storage device that are detected by the current detector during charging or discharging, perform a second estimation process to estimate an SOC of the electric storage device based on the open circuit voltage that is detected in detecting the open circuit voltage after charging or discharging, and perform a reset process to reset the initial amount of charge to the SOC of the electric storage device that is estimated in the second estimation process. In the electric storage condition detecting apparatus according to the eighth aspect, the initial amount of charge is not reset to the SOC that is estimated with using the charge/discharge current that is detected by the current detector and includes a measurement error caused by the current detector. The initial amount of charge is reset to the SOC that is estimated with using the open circuit voltage that is detected after the stabilizing time is elapsed and includes less occurrence of errors. Therefore, the measurement errors caused by the current detector during the present charging or discharging are less likely to be accumulated in next charging or discharging.

According to a ninth aspect, the electric storage device is a lithium ion secondary battery. In the electric storage condition detecting apparatus according to the ninth aspect, the stabilizing time for the lithium ion secondary battery is correctly obtained.

First Embodiment

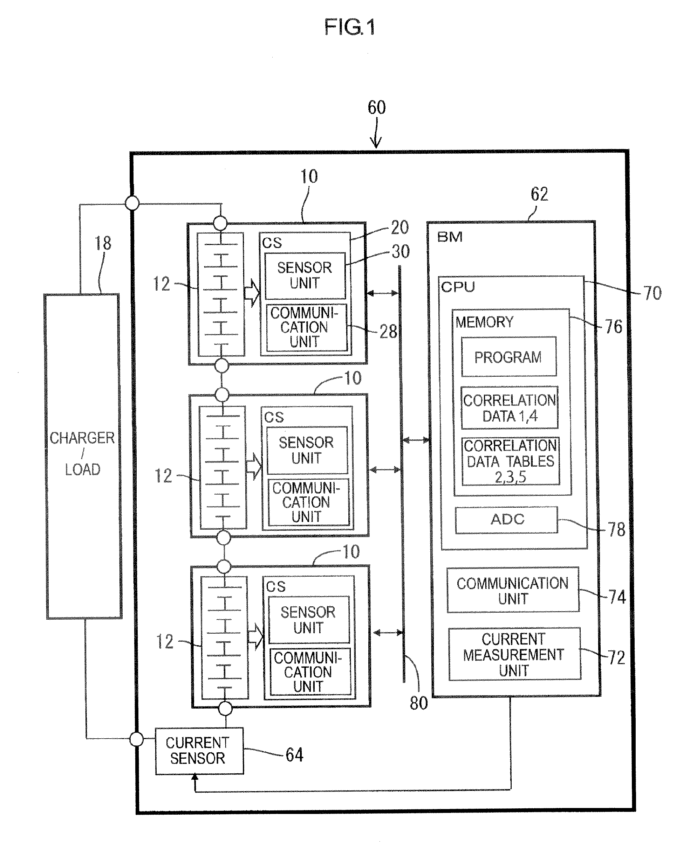

A first embodiment will be described with reference to FIGS. 1 to 6 and FIGS. 10 to 12.

1. Configuration of Battery Pack

A configuration of a battery pack 60 according to this embodiment is illustrated in FIG. 1. The battery pack 60 is installed in an electric vehicle or a hybrid vehicle, for example, to supply power to a motor (an electrically-powered device) that operates with electrical energy.

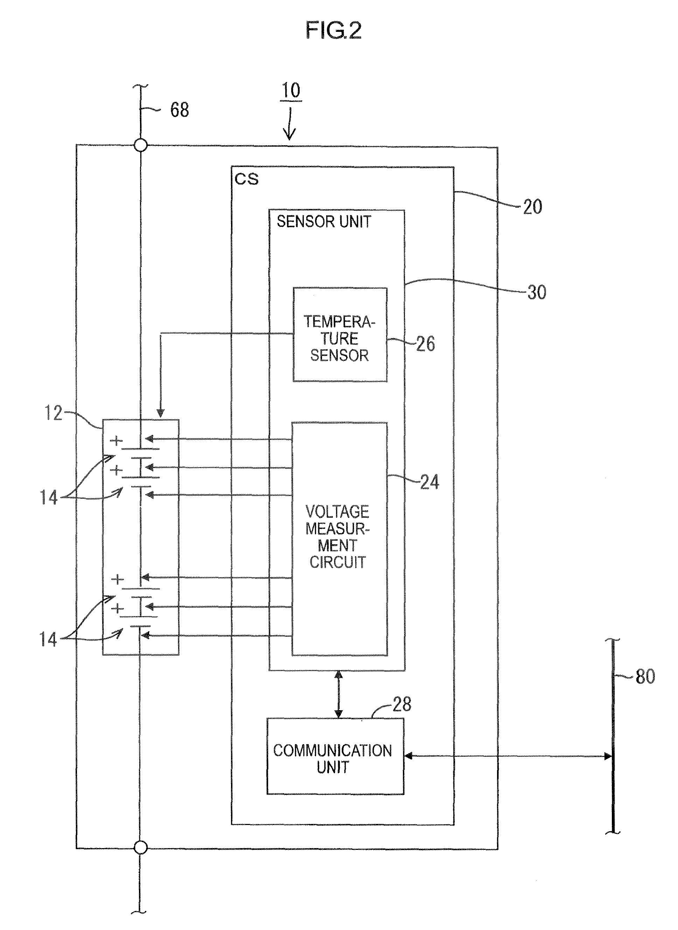

As illustrated in FIG. 1, the battery pack 60 includes battery modules 10, a battery manager (hereinafter referred to as the BM) 62, and a current sensor 64. Each battery module 10 includes an assembled battery 12 and a cell sensor (hereinafter referred to as the CS) 20. The assembled battery 12 includes secondary batteries 14 (see FIG. 2). The cell sensor 20 is a board on which a sensor unit 30 and a communication unit 28 are arranged. The BM 62 manages the battery module 10. The BM 62 and the CS 20 are an example of an electric storage condition detecting apparatus.

The assembled batteries 12 in the battery modules 10 and the current sensor 64 are connected in series via an electric line 68 and to a charger mounted in the vehicle or to a load such as a motor disposed in the vehicle.

The BM 62 includes a central processing unit (hereinafter referred to as the CPU) 70, a current measurement unit 72, and a communication unit 74. The current measurement unit 72 measures a current value I of a charge current or a discharge current (hereinafter referred to as a charge/discharge current) of each assembled battery 12 every predetermined period using the current sensor 64. The CPU 70 is an example of a controller.

As illustrated in FIG. 1, the CPU 70 includes memory 76 and an analog-digital converter (hereinafter referred to as the ADC) 78. Examples of the memory 76 include ROM and RAM. The ADC 78 converts the current I that is measured as an analog signal to a digital value. The memory 76 stores various programs for controlling operations of the CS 20 (including a battery management program). The CPU 70 controls components of the battery pack 60 according to programs read out of the memory 76, for example, by executing an SOC estimation sequence, which will be described later.

The SOC stands for state of charge, which represents a charged condition of a secondary battery. In this specification, the SOC is defined by a following equation (1).

$$SOC = Y/Y_0 \times 100 \ \ldots\ldots\ (1)$$

"Y" represents an amount of charge (a residual capacity) of a secondary battery 14, and "Yo" represents a fully-charged capacity of the secondary battery 14.

The memory 76 stores data that is required for performing the SOC estimation sequence such as correlation data 1 and 4 representing a relationship between open circuit voltages of the secondary battery 14 and the SOCs and correlation data tables 2, 3, 5 each representing a relationship between an amount of charge Y and stabilizing time T. Because the amount of charge Y is calculated in the SOC estimation sequence, the memory 76 stores the SOC before starting of charging or discharging and the fully-charged capacity Yo of the secondary battery 14.

The communication unit 74 is connected to the CSs 20 in the battery modules 10 via a communication line 80. The communication unit 74 receives information including voltages V and temperatures H measured in the CSs 20, which will be described later. The CPU 70 monitors a condition of the assembled battery 12 and estimates a capacity of each secondary battery 14 using such information.

The battery pack 60 also includes an operation unit (not illustrated) for receiving inputs from a user and a liquid crystal display (not illustrated) for displaying deterioration levels of the assembled batteries 12 and other information.

A schematic configuration of the battery module 10 is illustrated in FIG. 2. Each assembled battery 12 includes the secondary batteries 14 each of which is repeatedly chargeable and dischargeable. Examples of such a second battery include a ternary lithium ion secondary battery and an olivine-iron lithium ion secondary battery. Each CS 20 includes a sensor unit 30 and a communication unit 28. The sensor unit 30 includes a voltage measurement circuit 24 and a temperature sensor 26. The voltage measurement circuit 24 is an example of a voltage detector.

The ternary lithium ion secondary battery includes a lithium-contained metal oxide containing cobalt (Co), manganese (Mn), and nickel (Ni) as a positive electrode active material. The olivine-iron lithium ion secondary battery includes an olivine-type iron phosphate that is lithium iron phosphate (LeFeP04) as the positive electrode active material. Graphite, carbon or the like may be used as a negative electrode active material.

The voltage measurement circuit 24 is connected across each secondary battery 14 in the assembled battery 12. The voltage measurement circuit 24 measures a voltage V (V) across each secondary battery 14 every predetermined period. The temperature sensor 26 is a contact-type or a non-contact-type sensor. The temperature sensor 26 measures a temperature H (°C) of each secondary battery 14 in the assembled battery 12 every predetermined period.

The communication unit 28 is connected to the BM 62 via the communication line 80. The communication unit 28 sends information including the voltage V and the temperature H measured by the CS 20 to the BM 62.

The BM 62 stores the voltage V and the temperature H sent by each CS 20 in the memory 76.

2. Estimation of Stabilizing Time T

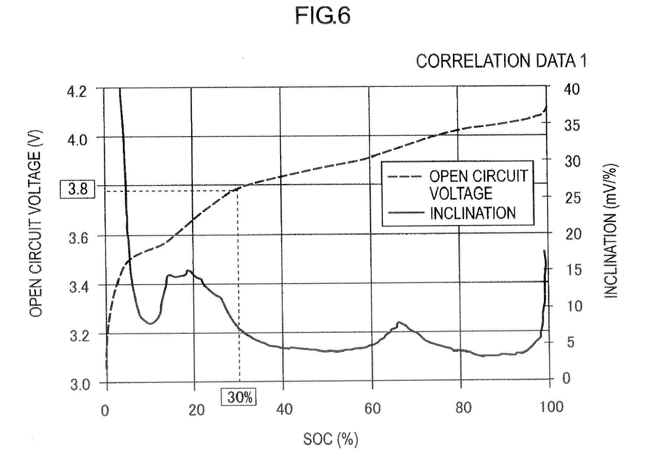

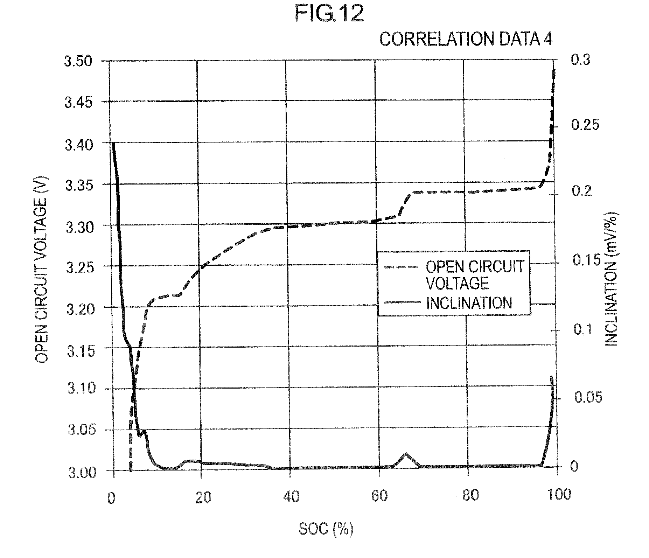

A predetermined time is usually required to stabilize the open circuit voltage (a terminal voltage) of the secondary battery 14 after charging or discharging is completed and a current is considered to be zero. Therefore, to measure a stable open circuit voltage of the secondary battery 14, it is necessary to wait until a stabilizing time T is elapsed after a current is considered to be zero. This takes longer time to measure the open circuit voltage. The applicant made researches and carried out experiments repeatedly as to a relationship between the stabilizing time T and the amount of charge Y (Ah) of a secondary battery. FIGS. 6 is a graph illustrating a relationship between the open circuit voltages and the SOCs in a ternary lithium ion secondary battery and FIG. 12 is a graph illustrating a relationship between the open circuit voltages and the SOCs in an olivine-iron lithium ion secondary battery. As illustrated in FIGS. 6 and 12, an inclination of each graph is not constant. As a result of the researches and experiments, the applicant found out that a length of the stabilizing time T varies according to the amount of charge Y (Ah) in non-aqueous electrolyte secondary batteries such as the ternary lithium ion secondary battery and the olivine-iron lithium ion secondary battery. The stabilizing time T represents a time required for stabilizing the open circuit voltage of the secondary battery 14 after the current is considered to be zero. Stabilizing the open circuit voltage represents conditions including: after the current is considered to be zero, a voltage change amount in a unit time is zero or equal to a threshold value that is slightly greater than zero or smaller than the threshold value; or when the amount of charge or the SOC is estimated based on the open circuit voltage, an estimation error is zero or equal to a threshold value that is slightly greater than zero or smaller than the threshold value.

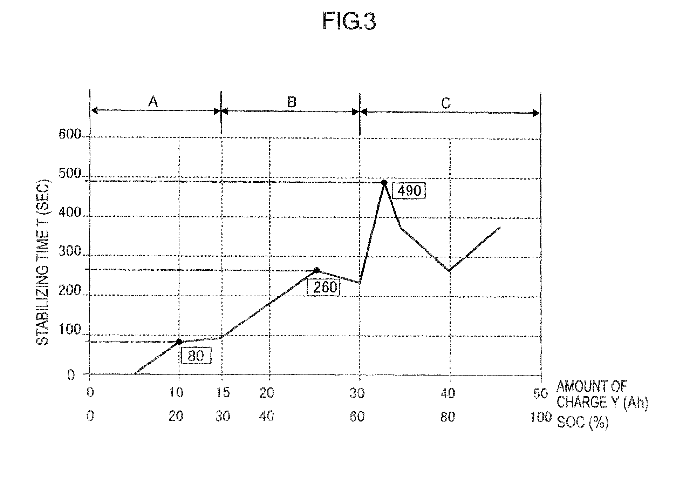

FIG. 3 illustrates the results of measured stabilizing time T for each amount of charge Y in the secondary battery (ternary lithium ion secondary battery) 14 having an initial capacity of 50 Ah. The stabilizing time T is measured at a temperature of 25 °C. In FIG. 3, a horizontal axis represents the amount of charge Y (Ah) and a vertical axis represents the stabilizing time T (sec). FIG. 3 also illustrates SOC values with respect to each amount of charge Y.

As illustrated in FIG. 3, the stabilizing time T of the secondary battery 14 exhibits different values according to the amount of charge Y. In the example in FIG. 3, the stabilizing time T substantially tends to be longer as the amount of charge Y increases. The stabilizing time T reaches a peak value when the amount of charge Y is in the vicinity of 32 Ah and the maximum value (the peak value) of the stabilizing time T is approximately 490 sec.

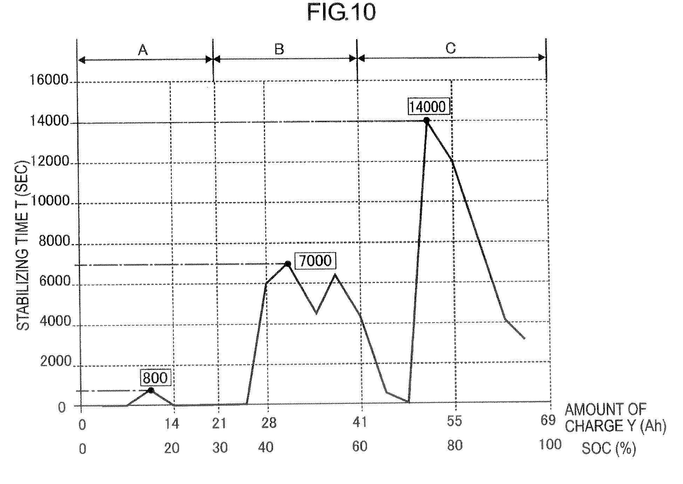

FIG. 10 illustrates the results of measured stabilizing time for each amount of charge Y under condition of a temperature of 25 °C in the secondary battery 14 (an olivine-iron lithium ion secondary battery) having an initial capacity of 69 Ah.

As illustrated in FIG. 10, the stabilizing time T of the secondary battery 14 exhibits different values according to the amount of charge Y in the olivine-iron lithium ion secondary battery. The stabilizing time T of the secondary battery 14 may exhibit different values according to a kind of the secondary battery 14. In the example of FIG. 10, the stabilizing time T reaches a peak value when the amount of charge Y is in the vicinity of 51 Ah and the maximum value (the peak value) of the stabilizing time T is approximately 14000 sec.

In this embodiment, the horizontal axis representing the amount of charge Y is divided into a plurality of ranges and the stabilizing time T is set for each of the ranges. Specifically, a maximum value of the stabilizing time T in each range is set as the stabilizing time T in the corresponding range. For example, as illustrated in FIG. 3, the horizontal axis representing the amount of charge Y is divided into three ranges including a range A from 0 Ah to 15 Ah, a range B from 15 Ah to 30 Ah, and a range C from 30 Ah to 50 Ah. In such a case, the stabilizing time T in the range A is 80 sec, the stabilizing time T in the range B is 260 sec, and the stabilizing time T in the range C is 490 sec.

As illustrated in FIG. 10, the horizontal axis representing the amount of charge Y is divided into three ranges including a range A from 0 Ah to 21 Ah, a range B from 21 Ah to 41 Ah, and a range C from 41 Ah to 69 Ah. In such a case, the stabilizing time T in the range A is 800 sec, the stabilizing time T in the range B is 7000 sec, and the stabilizing time T in the range C is 14000 sec.

Accordingly, the stabilizing time T is set to be shorter in the range that does not include the peak value compared to a case in which the stabilizing time is commonly set for all ranges. If the stabilizing time is commonly set for all the ranges, the length of the stabilizing time T is necessarily set to be 490 sec or 14000 sec each of which is the peak value in all the ranges to ensure the stabilizing time T for every amount of charge Y.

In this embodiment, the horizontal axis representing the amount of charge Y is divided into a plurality of ranges and the maximum value in each range is set as the stabilizing time T. Therefore, in the ranges A and B that do not include the whole range peak value, the length of the stabilizing time T is set to be a time that is shorter than the whole range peak value that is 490 sec or 14000 sec. Accordingly, the open circuit voltage of the secondary battery 14 is measured quickly and the SOC is estimated in a short time.

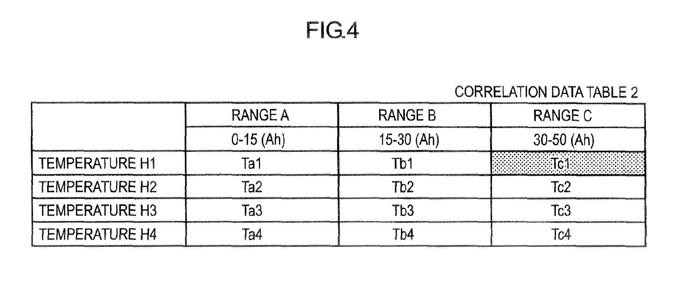

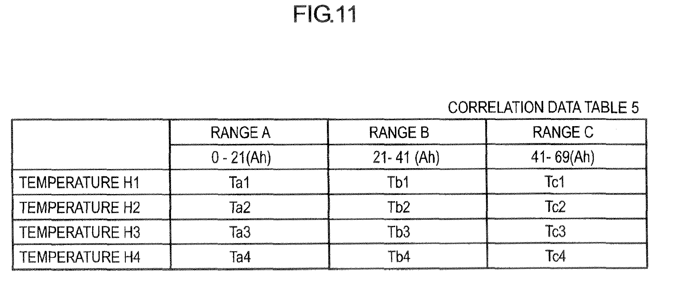

The stabilizing time T is influenced by the temperature H (°C). Therefore, in this embodiment, correlation data tables 2 and 5 each representing correlation between the stabilizing time T and the amount of charge Y for each temperature H (°C) are prepared as illustrated in FIGS. 4 and 11. The stabilizing time T is determined based on the temperature H and the amount of charge Y. Experiments of actually measuring the stabilizing time of the secondary battery 14 (a secondary battery same as the one that is to be measured) having each amount of charge Y are carried out in various temperature conditions. According to the experiments, the data in the correlation data tables 2 and 5 illustrated in FIGS. 4 and 11 is obtained.

3. SOC Estimation Sequence

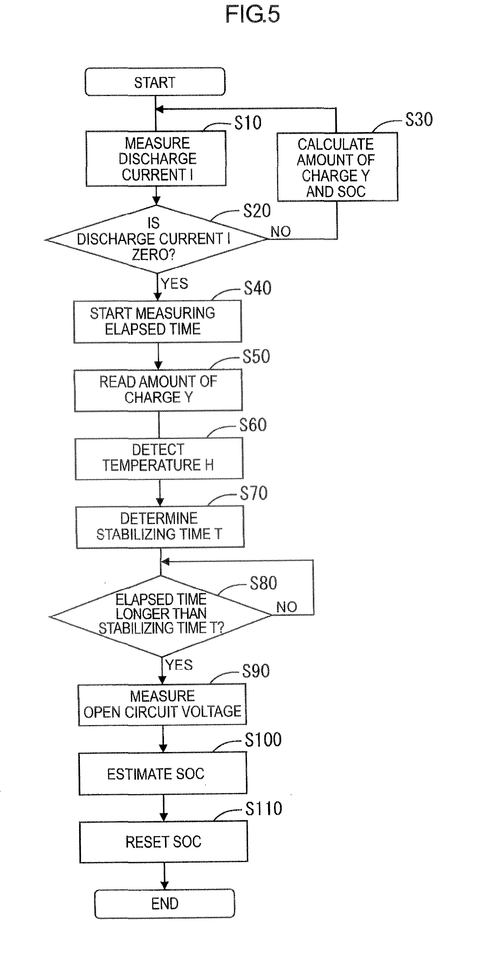

Next, the SOC estimation sequence for estimating an SOC of the secondary battery 14 will be explained with reference to FIG. 5. The SOC estimation sequence is performed by the CPU 70 of the BM 62 while the secondary battery 14 is under charge or discharge. Specifically, when the assembled batteries 12 of the battery pack 60 are under charge or when the load that is the motor of the vehicle is activated and the assembled batteries 12 are under discharge, the ECU mounted in a vehicle informs the BM 62 of status information. If receiving the status information, the CPU 70 of the BM 62 performs the SOC estimation sequence. In this embodiment, for example, such a sequence will be explained when ternary lithium ion secondary batteries are under discharge (when electric power is supplied from the assembled batteries 12 to the load that is the motor of the vehicle).

If the assembled batteries 12 start discharge according to the activation of the load that is the motor, the CPU 70 of the BM 62 receives the status information at the same time of starting discharging, and the CPU 70 starts a process of measuring discharge current I that is discharged from the assembled batteries 12 to the load. Specifically, the CPU 70 controls the current sensor 64 to measure the discharge current I via the current measurement unit 72 every predetermined period. A current value of the discharge current I that is measured by the current sensor 64 is sent to the BM 62 and converted to a digital value by the ADC 78 and stored in the memory 76.

The CPU 70 starts measuring the discharge current I at S10 and determines whether the charging or discharging is finished (S20). For example, to determine whether the charging or discharging is finished, the CPU 70 determines whether the current value of the discharge current I is zero. Specifically, the CPU 70 compares the current value of the measured discharge current I with a threshold value (the threshold value representing that the current value is considered to be zero). If the current value of the measured discharge current I is less than the threshold value, the CPU 70 determines that the current value of the discharge current I is zero.

While the load that is the motor is activated, the current value of the discharge current I is equal to or greater than the threshold value and the secondary battery 14 is under discharge. Therefore, a negative determination is made at S20. If the negative determination is made at S20, a process of accumulating the current values of the discharge current I at S30. The CPU 70 calculates the amount of charge Y of the secondary battery 14 with the following equation (2) and the calculated amount of charge Y is stored in the memory 76.

$$Y = Y1 \pm Yt \dots (2)$$

Y1 represents an amount of charge of a secondary battery before starting discharge (an example of an initial amount of charge).

Yt represents an accumulation value obtained by accumulating the current values of the discharge current I that is calculated in the accumulation process.

A sign of "'Yt" is "+" when the secondary battery is under charge, and it is "-" when the secondary battery is under discharge. The amount of charge Y1 of the secondary battery 14 before starting discharge is calculated based on the SOC value before starting discharge and the fully-charged capacity Yo value of the secondary battery 14 that are stored in the memory 76.

Further, the CPU 70 calculates an SOC based on the amount of charge Y at S30. Specifically, the CPU 70 assigns the amount of charge Y that is calculated in the above accumulation process and the fully-charged capacity Yo of the secondary battery 14 to the equation (1) to calculate the SOC. The fully-charged capacity Yo is estimated by a deterioration level of the secondary battery 14 and an initial fully-charged capacity (of a brand-new battery), for example. In this example, the fully-charged capacity Yo that is estimated and stored in the memory 76 is read from the memory 76 and used to estimate the SOC. The calculated SOC is stored in the memory 76.

The SOC is calculated based on the amount of charge Y that is the accumulation value obtained by accumulating the current values of the discharge current I at S30. Therefore, if a measurement error may occur in the current sensor 64, the accumulation value is obtained by accumulating the current values including such a measurement error. Accordingly, the SOC is not accurately calculated.

Then, the sequence returns to the process of S10. Thus, during the activation of the load, that is, while the secondary battery 14 is under discharge, the amount of charge Y and the SOC are calculated while the measurement of the discharge current I is repeatedly performed every predetermined period. The process of S30 that is performed by the CPU 70 achieves a first estimation process of the present invention.

If the discharging is stopped according to the stopping of the load of the charger/load 18, the current value of the discharge current I is substantially zero and is smaller than the threshold value. Therefore, an affirmative determination is made in the determination process of S20. If the affirmative determination is made at S20, the sequence proceeds to the process of S40. At S40, the CPU 70 starts a process of measuring elapsed time elapsed from a time when the current value of the discharge current I becomes zero. Thereafter, at S50, the CPU 70 reads the amount of charge Y that is calculated in the most recent process at S30.

After the amount of charge Y of the secondary battery 14 is read from the memory 76 in S50, a temperature H of the secondary battery 14 is measured at S60. Specifically, according to a command from the CPU 70, a temperature H of the secondary battery 14 is measured by the temperature sensor 26 of the CS 20. Information regarding the measured temperature H of the secondary battery 14 is sent to the BM 62 via the communication line 80. Then, the information is converted to a digital value by the ADC 78 and stored in the memory 76.

After the temperature H of the secondary battery 14 is measured, the sequence proceeds to S70. At S70, the CPU 70 determines a stabilizing time T based on the amount of charge Y read at S50 and the temperature H calculated at S60. Specifically, the CPU 70 determines the stabilizing time T with reference to the correlation data table 2 illustrated in FIG. 4. For example, if the temperature is H1 and the amount of charge Y is within the range from 30 to 50 Ah, the stabilizing time T of the secondary battery is determined to be Tc1. The process of S70 performed by the CPU 70 achieves a determination process of the present invention.

After determining the stabilizing time T, the CPU 70 determines whether the elapsed time elapsed from the determination that the current value of the discharge current I is zero is longer than the stabilizing time T (S80). If the elapsed time elapsed from the determination that the current value of the discharge current I is zero is equal to or shorter than the stabilizing time T, the CPU 70 makes a negative determination at S80 and waits for the time to be elapsed.

If the elapsed time elapsed from the determination that the current value of the discharge current I is zero is longer than the stabilizing time T, the CPU 70 makes an affirmative determination at S80 and proceeds to S90. At S90, a process of measuring the open circuit voltage (an example of an electric storage condition) of the secondary battery 14 is performed. Specifically, according to a command from the CPU 70, the open circuit voltage of the secondary battery 14 is measured via the voltage measurement circuit 24 of the CS 20. Information regarding the measured open circuit voltage of the secondary battery 14 is sent to the BM 62 via the communication line 80 and converted to a digital value by the ADC 78 and stored in the memory 76. The process of S90 performed by the CPU 70 achieves a voltage detection process of the present invention.

Thereafter, the sequence proceeds to S100 and a process of estimating an SOC of the secondary battery 14 is performed. The SOC is estimated with using the correlation data 1 representing a correlative relationship between the open circuit voltage (V) and the SOC (%) (data illustrated by a dashed line in FIG. 6). The process of S100 that is performed by the CPU 70 achieves a second estimation process of the present invention.

The correlation data 1 illustrated in FIG. 6 is previously stored in the memory 76 and if the sequence proceeds to S100, the correlation data 1 is read from the memory 76. The SOC of the secondary battery 14 is estimated with reference to the read correlation data 1. For example, if the open circuit voltage of the secondary battery 14 that is measured at S90 is 3.8 V, the SOC of the secondary battery 14 is estimated to be 30 %.

Then, the sequence proceeds to S110 and the SOC that is estimated at S100 is stored in the memory 76. At this time, the SOC that is stored in the memory 76 at S30 is overwritten, and the SOC stored in the memory 76 is reset to the SOC that is estimated at S100. Accordingly, the amount of charge Y that is calculated with using the equation (2) is reset to be the amount of charge Y1 before starting the discharging (charging) in a next SOC estimation sequence. The process of S110 that is performed by the CPU 70 achieves a reset process of the present invention. A series of processes for estimating the SOC is performed for each secondary battery 14 and if the processes for estimating the SOCs of all the secondary batteries 14 are finished, the SOC estimation sequence is terminated.

In the above description, the processes of estimating the SOCs of the secondary batteries 14 at the end of discharging are explained. If the SOCs of the secondary batteries 14 are estimated at the end of charging, the stabilizing time T is obtained based on information regarding the amount of charge Y and the temperature H at the end of charging. In the above description, the SOCs of the ternary lithium ion secondary batteries are estimated. However, estimation of the SOCs of the olivine-iron lithium ion secondary batteries may be also explained similarly.

4. Effects of This Embodiment

The BM 62 of the first embodiment determines the stabilizing time T based on a charged capacity of the secondary battery 14 (namely, an amount of charge Y). Therefore, the stabilizing time T is accurately obtained compared to a case in which the stabilizing time T is obtained without considering the amount of charge Y of the secondary battery 14. Accordingly, the waiting time required for stabilizing the open circuit voltage is shortened to be minimum. Therefore, the open circuit voltage is measured in a short time.

Because the open circuit voltage is measured in a short time, the SOC is also estimated in a short time.

Because the SOC is estimated in a short time, the SOC is reset to be a new value in a short time.

The BM 62 of the first embodiment determines the stabilizing time T based on the amount of charge Y and determines a reset time period that is from determination that the current value of the discharge current I is zero to the resetting of the SOC. Therefore, the reset time period of the SOC varies according to the amount of charge Y. If the battery pack 60 of the first embodiment is mounted in an electric vehicle, the reset time period varies according to the amount of charge Y. In such a case, the reset time period is from stopping of the electric vehicle or stopping of usage of the electric vehicle such as end of charging until resetting of the remaining mileage that is calculated based on the SOC of the secondary batteries 14. The remaining mileage means a range of the electric vehicle that can be achieved by the amount of charge Y of the secondary batteries 14 and displayed on an inner panel or the like of the electric vehicle.

Specifically, if the ternary lithium ion secondary batteries or the olivine-iron lithium ion secondary batteries are used, the reset time period of the remaining mileage becomes substantially longer as the amount of charge Y increases. The reset time period required for resetting the remaining mileage from 35 km to 30 km in case that the amount of charge Y is 10 Ah is shorter than the reset time period required for resetting the remaining mileage from 110 km to 105 km in case that the amount of charge Y is 32 Ah.

Second Embodiment

A second embodiment will be explained with reference to FIGS. 3, 7 and 8.

In the first embodiment, it is focused on that the stabilizing time T varies according to the amount of charge (Ah) and the stabilizing time T is determined based on the amount of charge Y. As illustrated in FIG. 3, the stabilizing time T also varies according to the SOC (%). In the second embodiment, it is focused on that the stabilizing time T varies according to the SOC (%), and the stabilizing time T is determined based on the SOC (%).

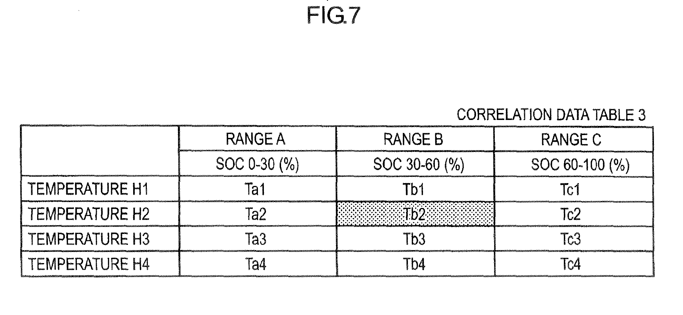

Specifically, in the second embodiment, the stabilizing time T is actually measured for the secondary battery 14 having different SOCs and such measurement experiments are performed in various temperature conditions. A correlation data table 3 representing a correlative relationship between the stabilizing time and the SOC in relation to each temperature is generated based on the obtained experiment values as illustrated in FIG. 7. The correlation data table 3 is previously stored in the memory 76. In an execution procedure of an SOC estimation sequence that will be explained below, the SOC and the temperature H (°C) of the secondary battery 14 are measured (S55, S60), and with reference to the correlation data table 3 stored in the memory 76, the stabilizing time T is calculated (S70) based on the obtained data regarding the SOC and the temperature H (°C).

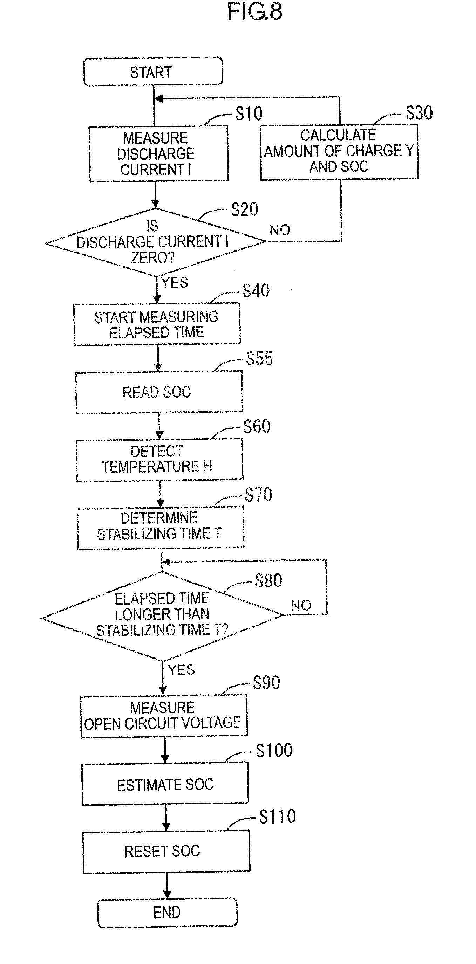

The SOC estimation sequence according to the second embodiment (refer FIG. 8) is modified from the SOC estimation sequence according to the first embodiment in that the process of S50 is deleted and the process of S55 is added. In the following description, the same configurations will be simply described and different configurations will be explained in detail.

If the assembled batteries 12 start discharging according to the activation of the load that is the motor, the CPU 70 starts a process of measuring the discharge current I of the assembled batteries 12 (S10). Then, during the activation of the load, that is, while the secondary battery 14 is under discharge, the amount of charge Y and the SOC are calculated while the measurement of the discharge current I is repeatedly performed every predetermined period (S20, S30). If the discharging is stopped according to stopping of the load and the current value of the discharge current I is substantially zero, an affirmative determination is made at S20. The sequence proceeds to S40 and the CPU 70 starts a process of measuring elapsed time elapsed from a time when the current value of the discharge current I becomes zero.

Thereafter, at S55, the CPU 70 reads the SOC that is calculated in the most recent process at S30. After the SOC is read from the memory 76, a temperature H of the secondary battery 14 is measured at S60. Specifically, according to a command from the CPU 70, a temperature H (°C) of the secondary battery 14 is measured by the temperature sensor 26 of the CS 20.

After the temperature H (°C) of the secondary battery 14 is measured, the sequence proceeds to S70. At S70, the CPU 70 determines a stabilizing time T based on the SOC read at S55 and the temperature H (°C) calculated at S60. Specifically, the CPU 70 determines the stabilizing time T with reference to the correlation data table 3 illustrated in FIG. 7. For example, if the temperature is H2 and the SOC is within the range from 30 to 60 %, the stabilizing time T of the secondary battery is determined to be Tb2.

After determining the stabilizing time T, the CPU 70 determines whether the elapsed time elapsed from the determination that the current value of the discharge current I is zero is longer than the stabilizing time T (S80). If the elapsed time elapsed from the determination that the current value of the discharge current I is zero is equal to or shorter than the stabilizing time T, the CPU 70 makes a negative determination at S80 and waits for the time to be elapsed.

If the elapsed time elapsed from the determination that the current value of the discharge current I is zero is longer than the stabilizing time T, the CPU 70 makes an affirmative determination at S80 and proceeds to S90. At S90, a process of measuring the open circuit voltage of the secondary battery 14 is performed. Information regarding the measured open circuit voltage of the secondary battery 14 is sent to the BM 62 via the communication line 80 and converted to a digital value by the ADC 78 and stored in the memory 76.

Thereafter, the sequence proceeds to S100 and a process of estimating an SOC of the secondary battery 14 is performed. The SOC is estimated with using the correlation data 1 representing a correlative relationship between the open circuit voltage and the SOC (data illustrated by a dashed line in FIG. 6).

After the SOC is estimated at S100, the sequence proceeds to S110. At S110, the SOC that is estimated at S100 is stored in the memory 76 and the SOC stored in the memory 76 at S30 is reset to the SOC that is estimated at S100.

In the SOC estimation sequence illustrated in FIG. 8, the SOC is estimated at S100 after the SOC is read at S55. At S55, the SOC that is calculated based on the accumulation value of the current values of the discharge current I at S30 is read from the memory 76. If a measurement error may occur in the current sensor 64, the accumulation value is obtained by accumulating the current values including such a measurement error at S30. Therefore, the SOC is not accurately calculated. Namely, the SOC that is read at S55 is an approximate value that is used to obtain the stabilizing time T. On the other hand, at S100, the SOC is obtained without using the current sensor 64. Therefore, the accumulation value does not include any errors and the SOC is estimated precisely.

The BM 62 of the second embodiment determines the stabilizing time T based on the SOC of the secondary battery 14. Therefore, the stabilizing time T is accurately obtained compared to a case in which the stabilizing time T is determined without considering the SOC of the secondary battery 14. Accordingly, the waiting time required for stabilizing the open circuit voltage is shortened to be minimum. Therefore, the open circuit voltage is measured in a short time and the SOC is estimated in a short time.

Third Embodiment

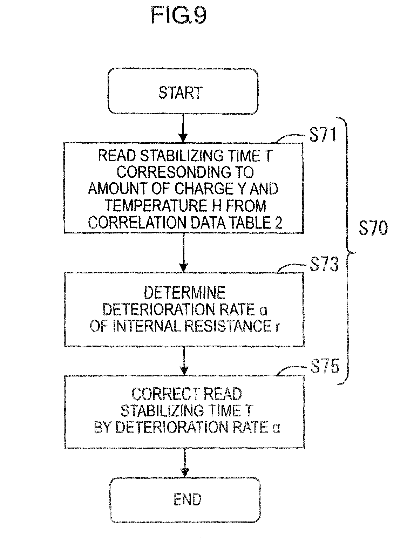

A third embodiment will be explained with reference to FIGS. 4 and 9.

In the first embodiment, the stabilizing time T is determined based on the temperature H and the amount of charge Y of the secondary battery. In the third embodiment, the stabilizing time T is determined based on the temperature H and the amount of charge Y of the secondary battery and a deterioration rate α of internal resistance r of the secondary battery 14.

The deterioration rate α of the internal resistance r represents a deterioration degree of the internal resistance r in case that an initial value ro is a reference value. For example, the deterioration rate α of the internal resistance r is calculated based on a following equation (3). In such a case, the deterioration rate α of the internal resistance r is 100 % in an initial product without deterioration and the deterioration rate α of the internal resistance r is greater than 100 % in a deteriorated product.

$$\alpha = (r/ro) \times 100 \ \ldots\ldots (3)$$

"ro" represents an initial value of the internal resistance of the secondary battery 14, and "r" represents a value of the internal resistance.

In the third embodiment, the stabilizing time T that is determined based on the amount of charge Y and the temperature H is corrected according to the deterioration rate α of the internal resistance r. Namely, each stabilizing time T illustrated in the correlation data table 2 in FIG. 4 according to the first embodiment is corrected according to the deterioration rate α to obtain final stabilizing time.

Specifically, in the third embodiment, the process contents of S70 in the SOC estimation sequence are different from those in the first embodiment, and the process of calculating the stabilizing time T in S70 includes S71 to S75.

At S71, the CPU 70 reads the stabilizing time T corresponding to the amount of charge Y and the temperature H from the correlation data table 2 illustrated in FIG. 4. At S73, the CPU 70 determines the deterioration rate α of the internal resistance r.

After determining the deterioration rate α, at S75, the CPU 70 corrects the stabilizing time T read at S71 according to the deterioration rate α of the internal resistance r that is determined at S73. Specifically, as illustrated in a following equation (4), the correction is made by multiplying the stabilizing time T by the deterioration rate α. Then, a correction process of correcting the stabilizing time T is terminated.

$$Tv = T \times \alpha \ldots (4)$$

In the third embodiment, after waiting until the corrected stabilizing time Tv is elapsed from the time that the current value of the discharge current I becomes zero and the corrected stabilizing time Tv is elapsed, the CPU 70 measures the open circuit voltage of the secondary battery 14 and performs the process of estimating the SOC.

The stabilizing time T tends to be longer as the deterioration degree of the internal resistance r increases. Therefore, if the stabilizing time T is corrected according to the internal resistance r, the stabilizing time T is correctly calculated compared to a case in which the stabilizing time T is calculated without considering the deterioration rate α of the internal resistance r.

The internal resistance r of the secondary battery 14 is calculated with arithmetic processing based on measurement data such as voltage values or current values of the secondary battery 14 under charge or discharge. Namely, if a regression line in relation to currents and voltages is obtained based on the measured currents and the measured voltages, an inclination of the obtained regression line represents the internal resistance r. Therefore, if the initial value ro of the internal resistance of the secondary battery 14 is stored, the deterioration rate α of the internal resistance r is calculated. The internal resistance r may be estimated in relation to a capacity maintenance ratio of the secondary battery 14. For example, if the capacity maintenance ratio is 100 %, the resistance value of the internal resistance r is related to XmΩ, and if the capacity maintenance ratio is 90 %, the resistance value of the internal resistance r is related to YmΩ, and accordingly, the internal resistance r is estimated according to the capacity maintenance ratio.

Other Embodiments

The present invention is not limited to the embodiments described above and illustrated in the drawings. The following various embodiments are also included in the technical scope of the present invention.

(1) In the first to third embodiments, the lithium ion secondary battery is described as an example of the electric storage device. However, the electric storage device is not limited to such an example, and secondary batteries other than the lithium ion secondary batteries or a capacitor providing an electrochemical action may be used as the electric storage device.

In such a case, the secondary battery or the capacitor may have characteristics that the inclination of the graph illustrating a relationship between the open circuit voltage and the SOC is not constant. In such a secondary battery or a capacitor, the stabilizing time T is likely to vary according to different amounts of charge or different SOCs. Therefore, the stabilizing T is determined based on the amount of charge Y, and accordingly, the open circuit voltage is effectively measured in a short time.

(2) In the first embodiment, the amount of charge Y (Ah) is used as an example of data relating to a charging capacity of an electric storage device. In the second embodiment, the SOC is used as an example of such data. Other than such data, data that is correlated with the amount of charge Y or the SOC such as the open circuit voltage (OCV) that is correlated with the SOC (the correlation data 1) may be used as the data relating to the charging capacity of an electric storage device.

(3) In the first embodiment, the stabilizing time T of the open circuit voltage is determined based on the amount of charge Y and the temperature H. In the second embodiment, the stabilizing time T of the open circuit voltage is determined based on the SOC and the temperature H. According to the present invention, the stabilizing time T of the open circuit voltage is determined based on data relating to a charging capacity of the secondary battery 14 such as the amount of charge Y or the SOC and may be determined based on only one of the amount of charge Y and the SOC. In the third embodiment, the stabilizing time T of the open circuit voltage is determined based on the amount of charge Y, the temperature H, and

the deterioration rate $\alpha$ of the internal resistance r. However, the stabilizing time T may be determined by the amount of charge Y and the deterioration rate $\alpha$ of the internal resistance r.

(4) In the first to third embodiments, the CPU 70 is used as an example of a controller. However, the controller may include multiple CPUs or a hardware circuit such as an application specific integrated circuit (ASIC). The controller may include both hardware circuit and CPU.

(5) In the first to third embodiments, the open circuit voltage is used for estimating the SOC. However, the open circuit voltage may not be limited to be used for estimating the SOC but may be used for determining the internal resistance r of the secondary battery 14. Thus, the open circuit voltage is not necessarily limited to specific applications.

(6) In the first to third embodiments, the SOC stored in the memory 76 is reset to the SOC that is estimated based on the open circuit voltage. However, the SOC is not necessarily reset to the estimated SOC. The SOC previously stored in the memory 76 and the estimated SOC may be both stored in the memory 76 for a comparison process, for example.

**Claims**

1. An electric storage condition detecting apparatus comprising:

   a voltage detector configured to detect a voltage of an electric storage device; and
   a controller configured to determine stabilizing time based on data corresponding to a charging capacity of the electric storage device, the stabilizing time being required for stabilizing an open circuit voltage of the electric storage device.

2. The electric storage condition detecting apparatus according to claim 1, wherein the data is an amount of charge.

3. The electric storage condition detecting apparatus according to claim 1, wherein the data is an SOC.

4. The electric storage condition detecting apparatus according to any one of claims 1 to 3, wherein the controller is configured to determine the stabilizing time based on the data and a temperature of the electric storage device.

5. The electric storage condition detecting apparatus according to any one of claims 1 to 3, wherein the controller is configured to determine the stabilizing time based on the data and a deterioration rate of an internal resistance of the electric storage device.

6. The electric storage condition detecting apparatus according to one of claims 4 and 5, wherein the controller is configured to determine the stabilizing time based on the data, the temperature of the electric storage device, and a deterioration rate of an internal resistance of the electric storage device.

7. The electric storage condition detecting apparatus according to any one of claims 1 to 6, wherein the voltage detector is configured to detect an open circuit voltage of the electric storage device after the stabilizing time is elapsed from end of charging or discharging.

8. The electric storage condition detecting apparatus according to claim 7, further comprising:

   a current detector configured to detect a charge current or a discharge current of the electric storage device, wherein the controller is further configured to:

   perform a first estimation process to estimate an SOC of the electric storage device based on an initial amount of charge before charging or discharging and an accumulation value of charge currents or discharge currents of the electric storage device that are detected by the current detector during charging or discharging;
   perform a second estimation process to estimate an SOC of the electric storage device based on the open circuit voltage that is detected in detecting the open circuit voltage after charging or discharging; and
   perform a reset process to reset the initial amount of charge using the SOC of the electric storage device that is estimated in the second estimation process.

9. The electric storage condition detecting apparatus according to any one of claims 1 to 8, wherein the electric storage device is a lithium ion secondary battery.

# FIG.1

# FIG.2

# FIG.3

FIG.4

CORRELATION DATA TABLE 2

|  | RANGE A<br>0-15 (Ah) | RANGE B<br>15-30 (Ah) | RANGE C<br>30-50 (Ah) |
|---|---|---|---|
| TEMPERATURE H1 | Ta1 | Tb1 | Tc1 |
| TEMPERATURE H2 | Ta2 | Tb2 | Tc2 |
| TEMPERATURE H3 | Ta3 | Tb3 | Tc3 |
| TEMPERATURE H4 | Ta4 | Tb4 | Tc4 |

# FIG.5

START

S10
MEASURE
DISCHARGE
CURRENT I

S30
CALCULATE
AMOUNT OF
CHARGE Y
AND SOC

S20
IS
DISCHARGE CURRENT I
ZERO?

NO

YES

S40
START MEASURING
ELAPSED TIME

S50
READ AMOUNT OF
CHARGE Y

S60
DETECT
TEMPERATURE H

S70
DETERMINE
STABILIZING TIME T

S80
ELAPSED TIME
LONGER THAN
STABILIZING TIME T?

NO

YES

S90
MEASURE
OPEN CIRCUIT VOLTAGE

S100
ESTIMATE SOC

S110
RESET SOC

END

15

# FIG.6

CORRELATION DATA 1

FIG.7

CORRELATION DATA TABLE 3

|  | RANGE A | RANGE B | RANGE C |
| --- | --- | --- | --- |
|  | SOC 0-30 (%) | SOC 30-60 (%) | SOC 60-100 (%) |
| TEMPERATURE H1 | Ta1 | Tb1 | Tc1 |
| TEMPERATURE H2 | Ta2 | Tb2 | Tc2 |
| TEMPERATURE H3 | Ta3 | Tb3 | Tc3 |
| TEMPERATURE H4 | Ta4 | Tb4 | Tc4 |

# FIG.8

```
                    START

    S10                              S30
  MEASURE                    CALCULATE
  DISCHARGE              AMOUNT OF CHARGE Y
  CURRENT I                  AND SOC

                 S20
              IS                    NO
      DISCHARGE CURRENT I
            ZERO?

            YES
                         S40
      START MEASURING
       ELAPSED TIME

                         S55
         READ SOC

                         S60
          DETECT
       TEMPERATURE H

                         S70
        DETERMINE
     STABILIZING TIME T

                 S80
       ELAPSED TIME          NO
       LONGER THAN
     STABILIZING TIME T?

            YES
                         S90
         MEASURE
   OPEN CIRCUIT VOLTAGE

                         S100
       ESTIMATE SOC

                         S110
        RESET SOC

                    END
```

## FIG.9

```
┌─────────────────┐
│      START      │
└─────────────────┘
         │
         ▼
┌─────────────────────────┐  S71 ┐
│  READ STABILIZING TIME T │      │
│     CORRESONDING TO      │      │
│  AMOUNT OF CHARGE Y AND  │      │
│    TEMPERATURE H FROM    │      │   S70
│ CORRELATION DATA TABLE 2 │      │
└─────────────────────────┘      │
         │                        │
         ▼                        │
┌─────────────────────────┐  S73 │
│        DETERMINE         │      │
│    DETERIORATION RATE α  │      │
│   OF INTERNAL RESISTANCE r│     │
└─────────────────────────┘      │
         │                        │
         ▼                        │
┌─────────────────────────┐  S75 ┘
│      CORRECT READ        │
│    STABILIZING TIME T    │
│  BY DETERIORATION RATE α │
└─────────────────────────┘
         │
         ▼
┌─────────────────┐
│       END       │
└─────────────────┘
```

## FIG.10

## FIG.11

CORRELATION DATA TABLE 5

|  | RANGE A | RANGE B | RANGE C |
|---|---|---|---|
|  | 0 - 21(Ah) | 21- 41 (Ah) | 41- 69(Ah) |
| TEMPERATURE H1 | Ta1 | Tb1 | Tc1 |
| TEMPERATURE H2 | Ta2 | Tb2 | Tc2 |
| TEMPERATURE H3 | Ta3 | Tb3 | Tc3 |
| TEMPERATURE H4 | Ta4 | Tb4 | Tc4 |

## FIG.12

CORRELATION DATA 4

**EP 2 725 371 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2011169831 A